(19) Europäisches Patentamt

European Patent Office

Office européen des brevets

(11) **EP 2 169 679 A1**

(12) **EUROPEAN PATENT APPLICATION**

(43) Date of publication:
**31.03.2010 Bulletin 2010/13**

(51) Int Cl.:
*G11B 20/10* (2006.01)     *G11B 20/14* (2006.01)
*H04L 7/033* (2006.01)

(21) Application number: **08305614.3**

(22) Date of filing: **30.09.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **Thomson Licensing
92443 Issy-les-Moulineaux Cedex (FR)**

(72) Inventors:
• **Chen, Xiao-Ming
  30165 Hannover (DE)**

• **Theis, Oliver
  30655 Hannover (DE)**
• **Timmermann, Friedrich
  30823 Garbsen (DE)**
• **Kuang, Guo Ting
  c/o IFM Electronic Co. Ltd.
  Tianhe Bel Road, Tianhe District
  51620 Guangzhou (CN)**

(74) Representative: **Thies, Stephan
  Deutsche Thomson OHG
  European Patent Operations
  Karl-Wiechert-Allee 74
  30625 Hannover (DE)**

(54) **Method and apparatus for timing recovery from a noisy channel**

(57)     The invention proposes a PR level estimation method which jointly estimates multiple PR-levels based on multiple observations after an equalizer. Overlapping small sets of e.g. m=2 consecutive PR levels are jointly estimated based on corresponding sets of observations (samples). The set of samples and the set of associated PR levels can directly be input to the prior art formula for estimating timing error. Alternatively, from the multiple PR values available per each time index n, a single PR level may be derived e.g. by majority vote with or without weighting. The invention also describes a compact apparatus structure for realizing the method. It employs the fact that the set of possible PR-levels is fixed, and employs a scaling factor and a common term for subtraction.

Fig. 2

EP 2 169 679 A1

**Description**

Field of the invention

The present invention relates to timing recovery in read channel signal processing of storage systems.

Description

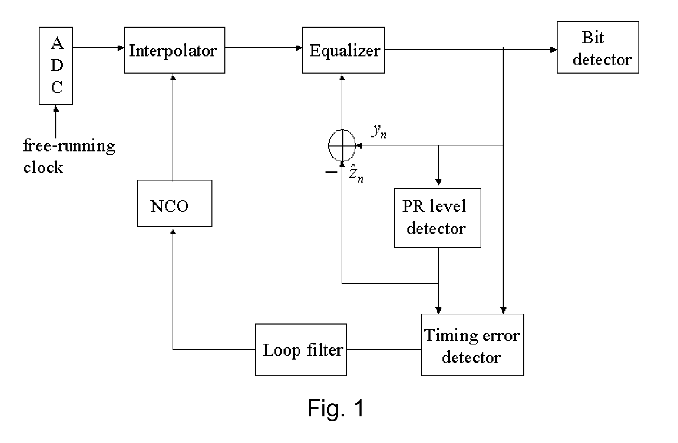

Timing recovery transfers the asynchronously sampled read-out signal to a baud rate synchronous signal, which is used for bit detection, RLL decoding (or joint bit detection/RLL decoding), and subsequent ECC decoding. A known structure of a fully digital implementation of a timing recovery loop is shown in **Fig. 1.** The timing recovery loop in Fig. 1 receives as input the asynchronously sampled read-out signal. The interpolator is also called sample rate converter, it converts from the system clock to the symbol clock, thus re-sampling the read-out signal at suitable time instances. Different timings result in different interpolator coefficients. After interpolation, the equalizer shapes the overall channel impulse response up to the bit detector to a desired partial response (PR) target. That is, in the ideal case (i.e., perfect timing recovery and perfect equalization) the equalizer output signal equals the convolution of the channel bits with the PR target impulse response plus filtered additive noise.

The re-sampling timing at the interpolator is adjusted by a digital phase locked loop (DPLL) comprising a timing error detector, a loop filter, and a numerically controlled oscillator (NCO). The timing phase error is derived by comparison of the equalizer output, denoted as $y_n$ at the re-sampling time index n, to the desired PR signal, denoted as $z_n$. A widely used timing error detector is as follows:

$$\Delta\tau_n = y_{n-1}z_n - y_n z_{n-1}, \qquad\qquad (1)$$

which tries to minimize the mean squared error between $y_n$ and $z_n$ via timing adjustment.

The $\Delta\tau_n$ from Eqn. (1) are used in the subsequent NCO as follows:

First, the detected timing error $\Delta\tau_k$ is passed through the loop filter (a second-order loop filter is comparable to a proportional-integral (PI) controller, where the integral part is used to deal with possible frequency errors.) The output of the loop filter is $\hat{\tau}_n = \hat{\tau}_{n-1} + \alpha\Delta\tau_n + (\alpha-\beta)\Delta\tau_{n-1}$. Two parameters $\alpha$ and $\beta$ control the loop bandwidth, the convergence speed, etc of the timing loop.

Then, the output of the loop filter is used in the NCO as follows:

$$t_n = nT + \hat{\tau}_n = (m_n + \mu_n)T_s$$

$$m_n = \text{int}\left[(nT + \hat{\tau}_n)/T_s\right]$$

$$\mu_n = (nT + \hat{\tau}_n)/T_s - m_n$$

where T and Ts denote the symbol clock (baud rate) period and the system clock period, respectively. The term "$t_n$" is the sampling timing for the n-th data symbol. The NCO evaluates "$m_n$" and "$\mu_n$", where the integer "$m_n$" indicates when the SRC performs the interpolation, and the value "$0 \leq \mu_n \leq 1$" selects the interpolation coefficients.

For the derivation of Eqn. (1) refer to "Phase error compensation for improved timing recovery," Y. Kim and J. Moon, IEEE Trans. Mag., pp. 2190-2191, Sept. 2000. See also "A PRML system for digital magnetic recording", R.D. Cideciyan et al, IEEE JSAC, pp. 38-56, Jan. 1992. For the adjustment of the timing loop, one has to distinguish between an acquisition step and a tracking step. During acquisition, a training sequence is used to adapt the equalizer and the feedback timing loop, where the desired PR signal $z_n$ is known. After acquisition, estimated PR signal levels from the PR-level detector, denoted as $\hat{z}_n$, are used in Eqn. (1) to eliminate any residual timing error and to track any signal variations.

Given the timing error detector (1), the tracking performance of the timing recovery loop depends on the decision reliability of the PR-level detector. A simple slicer has widely been used, see "A PRML system for digital magnetic recording", R.D. Cideciyan et al, IEEE JSAC, pp. 38-56, Jan. 1992, or U.S. Pat. No. 5,909,332, for example. A slicer individually compares single equalizer outputs to all possible PR-levels, and the PR-level with the minimum Euclidean distance to the equalizer output is selected as the slicer's decision (output).

For high density storage systems, the signal to noise ratio becomes low, while inter-symbol interference (ISI) becomes more severe. Under such conditions, a simple slicer cannot deliver reliable decisions for timing recovery. Therefore, a signal subspace detector was disclosed in U.S. Pat. Pub. No. 2002/0172305 for more reliable PR-level decisions at the expense of increased implementation complexity and decision delay. There, a few past and future observations are employed to estimate a current PR-level. A large decision delay results, which may degrade the tracking performance of the timing recovery loop. Moreover, different observations may undergo different timing errors under frequency errors, and involving several past and future observations may degrade the system performance, as shown later.

Known PR level detectors are either computationally complex or unreliable; an improvement is needed here, under the constraint that it must continue to allow exploiting (d,k) constraints of an underlying RLL code as much as possible.

Known PR level detectors are complex to implement; an improvement is needed here.

A good observation window length, which yields a good trade off between decision reliability and the influence of decision delay on timing error detection, has not yet been found.

For timing error detection and equalizer adaptation, estimates of PR-levels are necessary, rather than channel bit estimates, as shown in Fig. 1 and Eqn. (1). Because of the underlying PR-target and the (d,k) constraints of the employed RLL code, transitions between adjacent PR-levels are not arbitrary, which can be exploited to improve the reliability of PR-level estimation and consequently the overall system performance.

The current invention proposes a multiple PR-level detector which jointly estimates multiple PR-levels based on multiple observations after the equalizer. Employing the fact that the set of possible PR-levels is fixed and introducing a suitable scaling factor and a common term for subtraction, a simplified implementation of the proposed PR-level detector is presented.

In contrast to systems without timing error or with a slowly varying timing error, systems with timing error, when involving more observations for detection, may not necessarily result in a better decision, because different observations undergo different timing errors in the presence of a frequency error. Observations far away from the current observation may undergo a timing error, which possibly is quite different from the current one. Therefore, employing these observations may degrade the timing error detection performance rather than to improve it. As a design parameter, the number of observations, also referred to as the observation window length, resulting in the best performance can be obtained by evaluating the bit error rate (BER) performance of the bit detector in the presence of timing recovery loop.

According to the invention, timing recovery from a noisy channel signal comprises steps of:

- grouping overlapping sets of a number m of consecutive channel signal samples $(y_{n-m+1},...,y_n)$ from an interpolator into sample vectors y of predefined dimension m;
- deriving, from each sample vector y, an associated PR level vector z comprising a set of m consecutive PR levels $(z_{n-m+1},...,z_n)$;
- deriving, from the sample vector y and the associated PR level vector z, a timing error value $\Delta\tau$);
- using the timing error value $\Delta\tau_n$ to modify a sampling clock in the interpolator.

An apparatus according to the invention is a PR-level pair detector for PR timing recovery from interpolator output values. It comprises first adders equipped and configured to receive at their input two values selected from a current one of the interpolator output values, a delayed one of the interpolator output values, and a delayed and scaled one of the interpolator output values. It also comprises a comparator equipped and configured to receive each of the outputs of the first adders either directly or after passing through a second adder configured and equipped to add a constant value thereto; and to provide, at its output, an index corresponding to the smallest of its input values. It also comprises a lookup table containing (d,k)-constraint compliant PR-level pairs, equipped and configured to receive the index from the comparator and to provide, at its output, the PR-level pair corresponding to the index.

Advantages:

- The proposed PR-level detector provides reliable PR-level decisions under timing errors, which results in better timing and BER performance.

- A low-complexity hardware implementation is possible for the proposed PR-level detector.

Drawings

Exemplary embodiments of the invention are illustrated in the drawings and are explained in more detail in the following description.

In the figures:

Fig. 1        illustrates a known timing recovery loop with an embedded equalizer;

Fig. 2        shows a paired PR-level detector for the PR-121 channel using 16 adders, assuming $c_1=3, c_2=6$;

Figs. 3 a/b   show the mean of the timing error function for different multiple PR-level detectors; and

Fig.4         shows the BER performance comparison for different multiple PR-level detectors.

A multiple PR-level detector and its implementation

Denote as $Z = \{z^{(1)},...,z^{(i)},...,z^{(M)}\}$ the PR-level set for a given PR target taking d,k-constraints of the employed RLL code into account if applicable, where M is the number of possible PR-levels. On a symbol-by-symbol basis, a slicer estimates the PR-level as:

$$\hat{z}_n = \arg \min_{z^{(i)} \in Z} \{(y_n - z^{(i)})^2\} \, , \qquad\qquad (2)$$

where $z^{(i)}$ denotes that member of the PR-level set Z, that is being tested as the PR-level at the re-sampling time index n, and $\hat{z}_n$ denotes the associated estimate.

To improve decision reliability and the performance of the timing recovery loop, it is proposed to perform joint decision of multiple PR-levels based on multiple observations at each re-sampling time index n:

$$\hat{\mathbf{z}}_n = \arg \min_{\mathbf{z} \in Z^m} \{\|\mathbf{y}_n - \mathbf{z}\|^2\} = \arg \min_{\mathbf{z} \in Z^m} \{-2\mathbf{y}_n^T\mathbf{z} + \|\mathbf{z}\|^2\} \, , \qquad\qquad (3)$$

where

$\mathbf{y}_n = [y_{n-m+1},...,y_n]$ denotes the observation vector of length m,
$\mathbf{z} = \lfloor z^{(i_{n-m+1})},...,z^{(i_n)}\rfloor$ denotes the PR-level hypothesis vector having components from the PR-level set Z and belonging to a PR-level vector set $Z^m$, and $\hat{\mathbf{z}}_n = [\hat{z}_{n-m+1},...,\hat{z}_n]$ denotes the estimated PR-level vector; all having length (dimensionality) m, at the time index n, respectively. The PR-level vector set $Z^m$ is herein meant to denote the set of those hypothesis vectors that are compliant with the d,k-constraints of the RLL code, if applicable. Without any restrictions imposed by the RLL code or by the PR target, $Z^m$ would comprise $M^m$ members. However, with increasing observation window length m, an increasing number of these members are excluded because they violate either the minimum runlength constraint or the maximum runlength constraint. Note that for (d,k) RLL coding, after the NRZI postprocessing, the runlength of channel bit sequences is between d+1 and k+1. Assuming that the PR target has L+1 coefficients, if $L+m \geq k+1$, the d-constraint as well as the k-constraint must be considered to construct $Z^m$; otherwise (i.e. for shorter L+m), only the d-constraint must be considered.

In case of m>2, only the last two components of the PR value vector, namely the decisions for $z_n$ and $z_{n-1}$, are used in the timing error detection of Eqn. (1).

For the special case m=1, the multiple PR-level detector according to Eqn. (3) degenerates to the slicer approach of Eqn. (2). In contrast to this, the multiple PR-level detector of Eqn. (3) repeatedly uses each observation $y_n$ for m times and estimates $z_n$ for m times, which is necessary to deal with different timing errors at different re-sampling time indices.

Note that the signal subspace detector proposed in US 2002/0172305 assumes a fixed timing error at different time indices, which will reduce the robustness of that approach under frequency errors.

For the evaluation of Eqn. (3), $\{\|z^2\|\}$ can be pre-computed and stored in a look-up table. Furthermore, $y_{n-j}z^{(i_{n-j})}$ for $1 \leq j \leq m-1$ can be obtained by suitably delaying $Y_n z^{(i_n)}$, exploiting the fact that $z^{(i_{n-m+1})},...,z^{(i_n)} \in Z$. This formula describes that all the (scalar) component PR levels of the PR level vector are members of the PR level set Z. Consequently, the number of multipliers necessary for evaluation of Eqn. (3) only depends on the number of PR-levels. Another interpretation of the argument in Eqn. (3) is to perform the cross correlation between the observation vector $y_n$ and the hypothesis vector $z$ and to add a correction term $\|z\|^2$. To reduce the number of multipliers for implementation, that nonzero PR-level $z \in \{z^{(1)}, z^{(2)}, ..., z^{(M)}\}$ is searched, which is most often involved in hypothesis vectors $z = \lfloor z^{(i_{n-m+1})}, ..., z^{(i_n)} \rfloor$, after which all hypothesis vectors are scaled to that PR-level. Moreover, the most often appearing $\|z\|^2$ is subtracted from all correction terms, in order to reduce the number of adders. This procedure is further illustrated by the following example:

We assume a PR-[121] target and a RLL constraint of d=1, m=2. Then the set of PR-values is $Z^m$={(4,2), (4,4), (2,-2), (2,2), (2,4), (-2,-4), (-2,-2), (-2,2), (-4,-4), (-4,-2)}, where $Z$={$\pm 2, \pm 4$}. Note that due to the d-constraint, some transitions between subsequent PR-levels are not allowed, so that there are only 10 PR-level transitions rather than 16. The sets of -2$z$ and $\|z\|^2$ necessary for the evaluation of Eqn. (3) are listed in the following table:

Table 1: Coefficients used for the paired PR-121 level detector

| $(-2z^{(i_{n-1})}, -2z^{(i_n)})$ | $\|z\|^2$ |
|---|---|
| (-8, -4) | 20 |
| (-8, -8) | 32 |
| (-4, 4) | 8 |
| (-4, -4) | 8 |
| (-4, -8) | 20 |
| (4, 8) | 20 |
| (4, 4) | 8 |
| (4, -4) | 8 |
| (8, 8) | 32 |
| (8, 4) | 20 |

A suitable scaling factor for Table 1 is 4. After dividing all entries in Table 1 by 4, we obtain the following table:

Table 2: Coefficients used for the paired PR-121 level detector after scaling by 4

| $(-2z^{(i_{n-1})}, -2z^{(i_n)})/4$ | $\|z\|^2/4$ |
|---|---|
| (-2, -1) | 5 |
| (-2, -2) | 8 |
| (-1, 1) | 2 |
| (-1, -1) | 2 |
| (-1, -2) | 5 |
| (1, 2) | 5 |
| (1, 1) | 2 |
| (1, -1) | 2 |
| (2, 2) | 8 |
| (2, 1) | 5 |

A common subtraction term (i.e. offset) for the second column in Table 2 is 2. After subtracting 2, the second column contains values 3, 6, or 0.

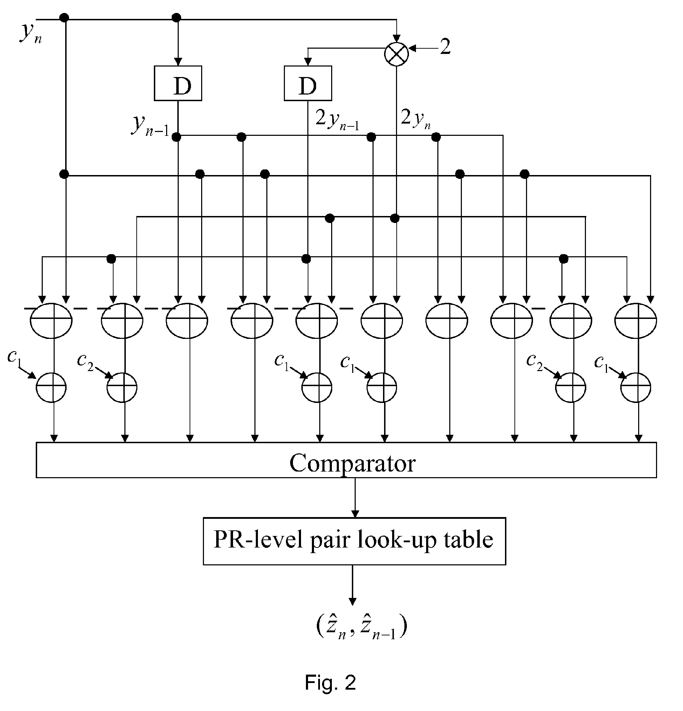

Fig. 2 shows an embodiment of the paired PR-level detector for the PR-121 channel using these settings. It uses 16 adders and the values $c_1$=3, $c_2$=6. The comparator finds, among all its inputs, the one with the minimum value, and the estimated PR-level pair is determined by accessing a lookup table containing {$(z^{(i_{n-1})}, z^{(i_n)})$}, i.e. the set of all PR-level pairs. In Fig. 2, the comparator has 10 inputs, where each input corresponds to a PR-level pair. Subsequently, two PR-level estimates are employed to determine the timing error according to Eqn. (1). The two inputs for the multiplier in Fig. 2 are $y_n$ and a constant "2", because we need $y_n$, $y_{n-1}$, $2y_n$, and $2y_{n-1}$ for the evaluation, as illustrated by the first column of Table 2. Next, ten adders are used to yield the ten combinations occurring in $-2y_n z^{(i_n)} - 2y_{n-1} z^{(i_{n-1})}$. Before the comparison, a possible correcting term is added according to the second column of Table 2. The comparator in Fig 2 outputs the minimum value of all its input values.

Selection of the observation window length m according to the BER performance

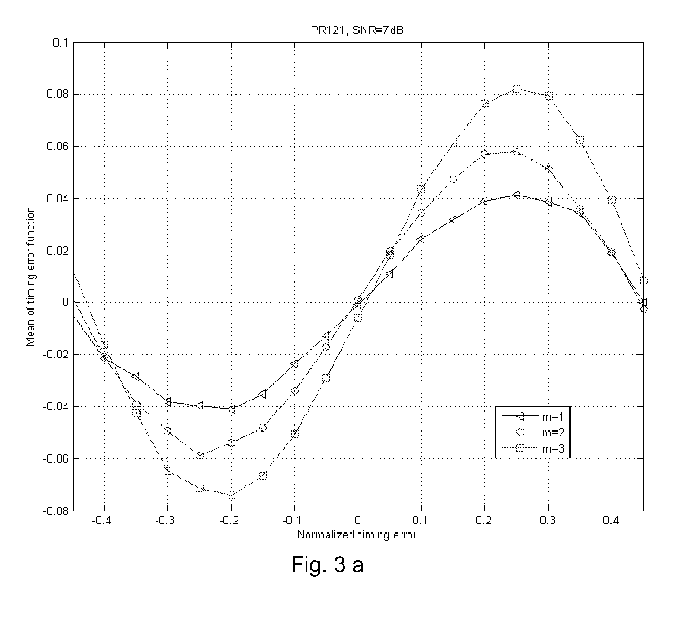

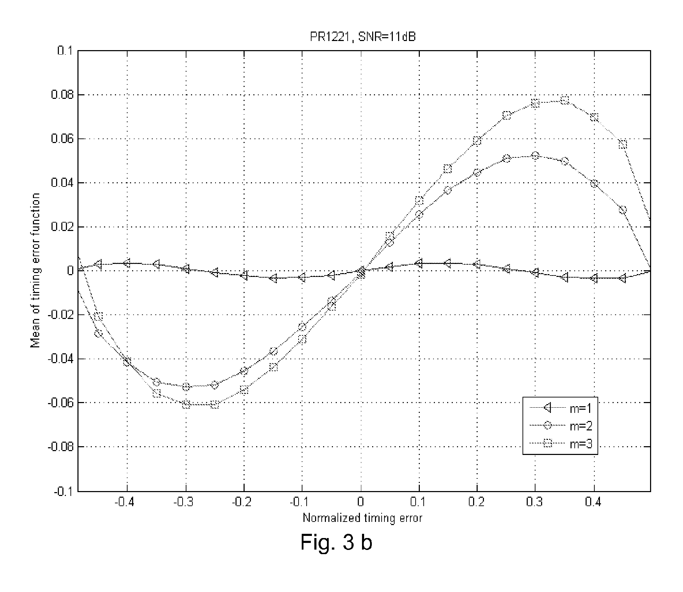

**Figs. 3a, 3b** illustrate the mean of the timing error function (2) employing the PR-level detector (3), for different m-values under the RLL d=1 constraint, for a PR-121 case (Fig. 3a) as well as for a PR-1221 case (Fig. 3b). In both diagrams, the x-axis shows the timing error normalized by the channel bit duration. The Figures show that increasing the observation window length m increases the linear region of the timing error around the origin, where the mean of the timing error function is proportional to the normalized timing error. Moreover, Fig. 3b shows that under medium or low SNRs, a simple slicer (m=1) fails to operate reliably for the PR1221-target.

However, when interpreting Figs. 3a, 3b, it must be kept in mind that results shown there were obtained assuming a fixed timing phase error and ideal PR channels. Real systems are likely to have a frequency error besides a fixed timing phase error, so that the total timing error is time variant rather than being constant. To compensate phase and frequency errors, a second-order loop filter is employed in the timing loop, as shown in Fig. 1. In addition, perfect equalization is also impossible. Therefore, results in Fig. 3 may not really reflect the performance of different PR-level detectors within the timing loop shown in Fig. 1.

To justify the performance of multiple PR-level detectors embedded in the timing recovery loop, the bit error rate after the bit detector is used for comparison.

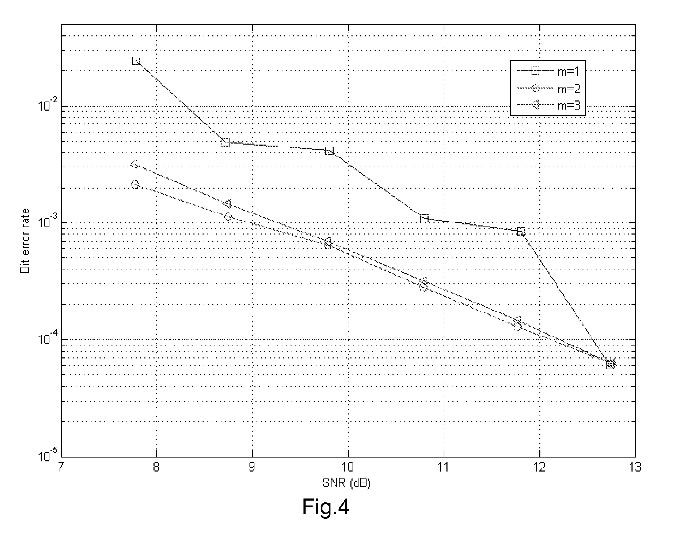

**Fig.4** shows the BER performance comparison for different multiple PR-level detectors, i.e. it shows the BER performance after the bit detector employing the timing recovery loop as Fig. 1. The investigated system models an asynchronously sampled read-channel of high-density optical storage systems as a Gaussian channel with a normalized information density of 4.3. This refers to the fact that the channel impulse response for optical storage can approximately be modeled as a Gaussian shape channel, and the storage density is characterized by a so-called "normalized information density". For the example of BluRay Disc (BD), the normalized information density is around 4.3. The underlying RLL code is a (1,9)-RLL code, a Max-LogAPP detector is employed for bit detection exploiting the d=1 constraint of the RLL code, and the PR-12221 target is chosen.

For medium and low SNRs, a simple slicer does not provide reasonable results. For high SNRs, different detectors exhibit a similar performance. Moreover, the PR-level detector with $m=2$ shows the best BER performance for the considered SNR region, i.e., a more complicated PR-level detector with m=3 does not provide a better performance. The reason for that can be explained as follows. For $m=3$, two previous interpolated samples are used to estimate the current timing error $\Delta\tau_n$, while these two previous samples undergo timing errors possibly different from the current one. Using the interpolated sample $y_{n-2}$ relatively far away from the current sample $y_n$ may degrade the system performance rather than improve it, especially under medium or low SNRs. Therefore, the PR-level detector with $m=2$ provides the best trade-off between the decision reliability and the influence of decision delay on timing error detection.

As already shown in Fig. 1, the PR-level detector delivers estimates used for both equalizer adaptation and timing error detector. Moreover, these estimates can also be used for the gain control, as shown in "A PRML system for digital magnetic recording", R.D. Cideciyan et al, IEEE JSAC, pp. 38-56, Jan. 1992.

With other words, the invention proposes a PR level estimation method which jointly estimates multiple PR-levels based on multiple observations after an equalizer. Overlapping small sets of e.g. m=2 consecutive PR levels are jointly estimated based on corresponding sets of observations (samples). The set of samples and the set of associated PR levels can directly be input to the prior art formula for estimating timing error. Alternatively, from the multiple PR values available per each time index n, a single PR level may be derived e.g. by majority vote with or without weighting. The invention also describes a compact apparatus structure for realizing the method. It employs the fact that the set of possible PR-levels is fixed, and employs a scaling factor and a common term for subtraction.

**Claims**

**1.**   A method for timing recovery from a noisy channel signal, comprising steps of:

> - grouping overlapping sets of a number m of consecutive channel signal samples ($y_{n-m+1},...,y_n$) from an interpolator into sample vectors (y) of predefined dimension (m);
> - deriving, from each sample vector (y), an associated PR level vector (z) comprising a set of m consecutive PR levels (zn-m+1,...,zn);
> - deriving, from the sample vector (y) and the associated PR level vector (z), a timing error value ($\Delta\tau$n);

- using the timing error value ($\Delta\tau n$) to modify a sampling clock in the interpolator.

2. A PR-level pair detector for timing recovery from interpolator output values, the detector comprising:

- first adders equipped and configured to receive at their input two values selected from a current one of the interpolator output values, a delayed one of the interpolator output values, and a delayed and scaled one of the interpolator output values,
- a comparator equipped and configured to receive each of the outputs of the first adders either directly or after passing through a second adder configured and equipped to add a constant value thereto; and to provide, at its output, an index corresponding to the smallest of its input values,
- a lookup table containing (d,k)-constraint compliant PR-level pairs, equipped and configured to receive the index from the comparator and to provide, at its output, the PR-level pair corresponding to the index.

Fig. 1

Fig. 2

Fig. 3 a

Fig. 3 b

Fig.4

Europäisches
Patentamt

European
Patent Office

Office européen
des brevets

**EUROPEAN SEARCH REPORT**

Application Number

EP 08 30 5614

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 246 723 B1 (BLISS WILLIAM G [US] ET AL) 12 June 2001 (2001-06-12) | 1 | INV. G11B20/10 G11B20/14 H04L7/033 |
| A | * column 1, lines 38-43 * <br> * column 2, lines 16-37 * <br> * column 4, lines 12-40 * <br> * column 6, line 35 - column 8, line 8 * <br> * column 8, line 10 - column 12, line 2 * <br> * column 14, lines 3-16 * <br> * column 14, lines 51-62 * <br> * column 15, lines 4-21 * <br> * figures 4,5A,5B,8 * <br> ----- | 2 | |
| A | US 6 469 851 B1 (ASHLEY JONATHAN [US] ET AL) 22 October 2002 (2002-10-22) <br> * abstract * <br> ----- | 1,2 | |
| D,A | CIDECIYAN R D ET AL: "A PRML SYSTEM FOR DIGITAL MAGNETIC RECORDING" <br> IEEE JOURNAL ON SELECTED AREAS IN COMMUNICATIONS, <br> vol. 10, no. 1, <br> 1 January 1992 (1992-01-01), pages 38-56, <br> XP000457625 <br> ISSN: 0733-8716 <br> * pages 38-43 * <br> ----- | 1,2 | TECHNICAL FIELDS SEARCHED (IPC) <br><br> G11B <br> H04L |
| D,A | YOUNGGYUN KIM ET AL: "Phase Error Compensation for Improved Timing Recovery" <br> IEEE TRANSACTIONS ON MAGNETICS, IEEE SERVICE CENTER, NEW YORK, NY, US, <br> vol. 36, no. 5, <br> 1 September 2000 (2000-09-01), XP011033282 <br> ISSN: 0018-9464 <br> * the whole document * <br> ----- | 1,2 | |

The present search report has been drawn up for all claims

| Place of search | Date of completion of the search | Examiner |
|---|---|---|
| The Hague | 16 March 2009 | Hermes, Lothar |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.................................................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 08 30 5614

This annex lists the patent family members relating to the patent documents cited in the above-mentioned European search report.
The members are as contained in the European Patent Office EDP file on
The European Patent Office is in no way liable for these particulars which are merely given for the purpose of information.

16-03-2009

| Patent document cited in search report | | Publication date | Patent family member(s) | | Publication date |
|---|---|---|---|---|---|
| US 6246723 | B1 | 12-06-2001 | NONE | | |
| US 6469851 | B1 | 22-10-2002 | US | 6549354 B1 | 15-04-2003 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5909332 A

- US 20020172305 A

**Non-patent literature cited in the description**

- **Y. Kim ; J. Moon.** Phase error compensation for improved timing recovery. *IEEE Trans. Mag.,* September 2000, 2190-2191

- **R.D. Cideciyan et al.** A PRML system for digital magnetic recording. *IEEE JSAC,* January 1992, 38-56